(19)

Europäisches
Patentamt
European
Patent Office
Office européen
des brevets

(11) **EP 3 930 188 A1**

(12) **EUROPEAN PATENT APPLICATION**
published in accordance with Art. 153(4) EPC

(43) Date of publication:
**29.12.2021 Bulletin 2021/52**

(21) Application number: **20759069.6**

(22) Date of filing: **17.01.2020**

(51) Int Cl.:
**H03G 3/10** (2006.01)   **H03H 11/10** (2006.01)
**H03H 11/44** (2006.01)   **H03F 1/56** (2006.01)

(86) International application number:
**PCT/JP2020/001605**

(87) International publication number:
**WO 2020/170668 (27.08.2020 Gazette 2020/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.02.2019   JP 2019027793**
**14.11.2019   JP 2019206582**

(71) Applicant: **Panasonic Intellectual Property Management Co., Ltd.**
**Osaka-shi, Osaka 540-6207 (JP)**

(72) Inventor: **SUWA, Atsushi**
**Osaka-shi, Osaka 540-6207 (JP)**

(74) Representative: **Appelt, Christian W.**
**Boehmert & Boehmert**
**Anwaltspartnerschaft mbB**
**Pettenkoferstrasse 22**
**80336 München (DE)**

(54) **AMPLIFIER CIRCUIT**

(57)     The problem to be overcome by the present invention is to provide an amplifier circuit that operates properly even when its input and output sections exchange their roles with each other. An amplifier circuit (1) according to the present invention includes a first block (B1), a second block (B2), a transformer (Z1), and a reference node (G1) and operates as a negative impedance converter circuit. A circuit configuration formed by a first transistor (Tr1) and at least one first passive component (R11, R12, C1) in the first block (B1) with respect to a first terminal (Ta1) of the transformer (Z1) and a circuit configuration formed by a second transistor (Tr2) and at least one second passive component (R21, R22, C2) in the second block (B2) with respect to a second terminal (Ta2) of the transformer (Z1) are the same as each other.

*FIG. 1*

EP 3 930 188 A1

**Description**

**Technical Field**

The present disclosure generally relates to an amplifier circuit, and more particularly relates to an amplifier circuit configured to provide a negative impedance through operations of transistors.

**Background Art**

Patent Literature 1 discloses an exemplary known negative impedance converter (NIC) circuit for providing a negative impedance.

The negative impedance converter circuit of Patent Literature 1 includes a first current path in which a constant current source and a first transistor are connected in series and a second current path in which the constant current source and a second transistor are connected in series and which is formed symmetrically with respect to the first current path. One of two differential input signals is provided to a control terminal of the second transistor via a first buffer. The one of the two differential input signals is further connected to a node of connection between the constant current source and the first transistor on the first current path via a second buffer. The other of the two differential input signals is provided to a control terminal of the first transistor via a third buffer. The other of the two differential input signals is further connected to a node of connection between the constant current source and the second transistor on the second current path via a fourth buffer.

There is an amplifier circuit which uses a negative impedance converter circuit as disclosed by Patent Literature 1. The amplifier circuit amplifies an input electrical signal and outputs the electrical signal thus amplified.

To have its assembling or hardwiring done more easily, the amplifier circuit suitably operates properly even when the input and output sections of the amplifier circuit exchange their roles with each other.

**Citation List**

**Patent Literature**

Patent Literature 1: JP 2005-286516 A

**Summary of Invention**

In view of the foregoing background, it is therefore an object of the present disclosure to provide an amplifier circuit configured to operate properly even when the input and output sections of the amplifier circuit exchange their roles with each other.

An amplifier circuit according to an aspect of the present disclosure includes a first block, a second block, a transformer, and a reference node and operates as a negative impedance converter circuit. The first block includes a first transistor and at least one first passive component. The second block includes a second transistor and at least one second passive component. The transformer has a first terminal thereof electrically connected to the first transistor and a second terminal thereof electrically connected to the second transistor. The reference node provides a reference potential. A circuit configuration formed by the first transistor and the at least one first passive component of the first block with respect to the first terminal and a circuit configuration formed by the second transistor and the at least one second passive component of the second block with respect to the second terminal are the same as each other.

An amplifier circuit according to another aspect of the present disclosure includes a first block, a second block, a transformer, and a reference node and operates as a negative impedance converter circuit. The first block includes a first transistor and at least one first passive component. The second block includes a second transistor and at least one second passive component. The transformer has a first terminal thereof electrically connected to the first transistor and a second terminal thereof electrically connected to the second transistor. The reference node provides a reference potential. A circuit configuration formed by the first transistor and the at least one first passive component of the first block and a circuit configuration formed by the second transistor and the at least one second passive component of the second block are symmetrical to each other with respect to the transformer.

**Brief Description of Drawings**

FIG. 1 is a circuit diagram illustrating an amplifier circuit according to a first embodiment of the present disclosure;

FIG. 2 schematically illustrates a configuration for an NIC circuit for use in the amplifier circuit;

FIG. 3A is a graph showing the frequency characteristic of the power amplification factor of a first output signal with respect to a first input signal in the amplifier circuit;

FIG. 3B is a graph showing the frequency characteristic of the power amplification factor of a second output signal with respect to a second input signal in the amplifier circuit;

FIG. 4 illustrates an equivalent circuit of an inductor of the amplifier circuit;

FIG. 5 schematically illustrates a circuit configuration between both terminals of a control power supply of the amplifier circuit;

FIG. 6 is a graph showing the frequency characteristic of a power amplification factor when a control voltage applied to the amplifier circuit has a value of 3 V;

FIG. 7 is a graph showing the frequency characteristic of a power amplification factor when the control voltage applied to the amplifier circuit has a value of 4 V;

FIG. 8 is a graph showing the frequency characteristic of a power amplification factor when the control voltage applied to the amplifier circuit has a value of 5 V;

FIG. 9 is a circuit diagram illustrating a first example of an amplifier circuit according to a second embodiment of the present disclosure;

FIG. 10 is a circuit diagram illustrating a second example of the amplifier circuit;

FIG. 11 is a circuit diagram illustrating a third example of the amplifier circuit;

FIG. 12 is a circuit diagram illustrating an exemplary application of the third example of the amplifier circuit;

FIG. 13 is a circuit diagram illustrating a fourth example of the amplifier circuit; and

FIG. 14 is a circuit diagram illustrating a fifth example of the amplifier circuit.

## Description of Embodiments

### (1) First embodiment

#### (1.1) Overview

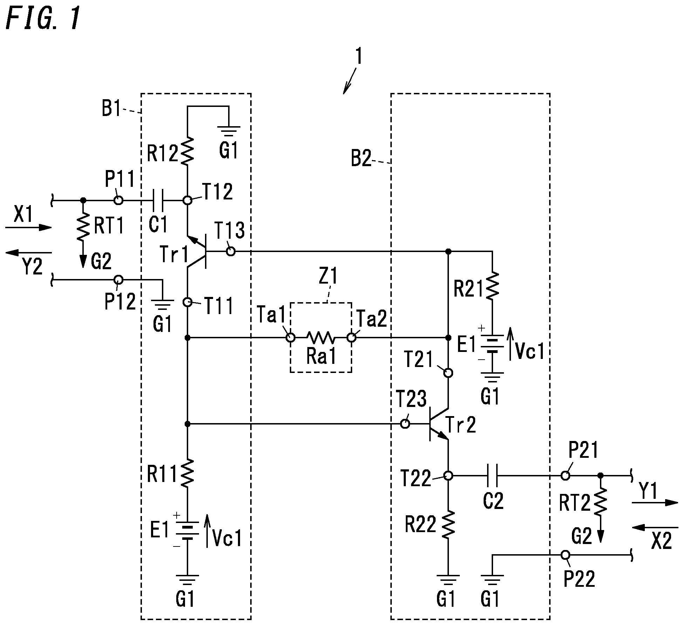

An amplifier circuit 1 according to a first embodiment will be described with reference to FIG. 1. The amplifier circuit 1 according to this embodiment may also function as a negative impedance converter circuit (hereinafter referred to as an "NIC circuit"). The NIC circuit has a circuit configuration based on a so-called "Linvill type" NIC circuit including two transistors serving as active components (namely, a first transistor Tr1 and a second transistor Tr2). That is to say, the amplifier circuit 1 is an amplifier circuit which may also function as an NIC circuit, i.e., a so-called "negative impedance amplifier circuit."

The amplifier circuit 1 includes a first block B1, a second block B2, a control power supply E1, and a transformer Z1. The first block B1 includes a first transistor Tr1 and at least one first passive component. In this embodiment, the at least one first passive component may include a resistor and a capacitor, for example. The second block B2 includes a second transistor Tr2 and at least one second passive component. In this embodiment, the at least one second passive component may include a resistor or a capacitor, for example. The transformer Z1 is an impedance element including a first terminal Ta1 and a second terminal Ta2 and having an impedance between the first terminal Ta1 and the second terminal Ta2. The first terminal Ta1 is electrically connected to the first block B1 and the second terminal Ta2 is electrically connected to the second block B2.

The amplifier circuit 1 suitably further includes a pair of first input/output terminals P11, P12 and a pair of second input/output terminals P21, P22. The transformer Z1 is electrically connected between the first input/output terminal P11 and the second input/output terminal P21. The first input/output terminal P12 and the second input/output terminal P22 are both electrically connected to the reference node G1. The reference node G1 may be a frame connected to a reference potential or a frame connected to the ground, for example. The potential at the reference node G1 serves as a reference potential for the amplifier circuit 1. Each of the pair of first input/output terminals P11, P12 and the pair of second input/output terminals P21, P22 is configured to include a terminal, a plug, a receptacle, or a conductor, for example.

A circuit configuration formed by the first transistor Tr1 and the at least one first passive component of the first block B1 with respect to the first terminal Ta1 of the transformer Z1 (i.e., as viewed from the first terminal Ta1) (hereinafter referred to as a "first circuit configuration") and a circuit configuration formed by the second transistor Tr2 and the at least one second passive component of the second block B2 with respect to the second terminal Ta2 of the transformer Z1 (i.e., as viewed from the second terminal Ta2) (hereinafter referred to as a "second circuit configuration") are the same as each other.

As used herein, if the first circuit configuration with respect to the first terminal Ta1 and the second circuit configuration with respect to the second terminal Ta2 are the same as each other, this means that the electrical connection of the first transistor Tr1 and the first passive component to the first terminal Ta1 and the electrical connection of the second transistor Tr2 and the second passive component to the second terminal Ta2 are the same as each other. Furthermore, the relative spatial positions of the first transistor Tr1 and the first passive component with respect to the first terminal Ta1 are suitably respectively the same as relative spatial positions of the second transistor Tr2 and the second passive component with respect to the second terminal Ta2.

In other words, the circuit configuration formed by the first transistor Tr1 and the at least one first passive component of the first block B1 (i.e., the first circuit configuration) and the circuit configuration formed by the second transistor Tr2 and the at least one second passive component of the second block B2 (i.e., the second circuit configuration) are symmetrical to each other with respect to the transformer Z1.

The amplifier circuit 1 according to this embodiment is configured such that the respective amplification functions of the first transistor Tr1 and the second transistor Tr2 make the impedance as viewed from the pair of first input/output terminals P11, P12 a negative impedance defined by inverting the sign of the impedance of the transformer Z1 from positive to negative, or vice versa. That is to say, although the impedance of the transformer Z1 is positive, the impedance as viewed from the pair of first input/output terminals P11, P12 of the amplifier circuit 1 becomes apparently a negative impedance defined by inverting the sign of the impedance of the transformer Z1 from positive to negative, or vice versa.

The amplifier circuit 1 according to this embodiment is further configured such that the respective amplification functions of the first transistor Tr1 and the second transistor Tr2 make the impedance as viewed from the pair of second input/output terminals P21, P22 a negative impedance defined by inverting the sign of the impedance of the transformer Z1 from positive to negative, or vice versa. That is to say, the impedance as viewed from the pair of second input/output terminals P21, P22 of the amplifier circuit 1 becomes apparently a negative impedance defined by inverting the sign of the impedance of the transformer Z1 from positive to negative, or vice versa.

(1.2) Details

Next, the amplifier circuit 1 according to the first embodiment will be described in detail with reference to FIG. 1.

Each of the first transistor Tr1 and the second transistor Tr2 is a general-purpose transistor and is suitably implemented as an npn bipolar transistor. In this embodiment, each of the first transistor Tr1 and the second transistor Tr2 is "2SC358" (or "NE68133") manufactured by Renesas Electronics Corporation. Each of the first transistor Tr1 and the second transistor Tr2 is electrically connected to the transformer Z1.

The first transistor Tr1 has three terminals, namely, a collector T11, an emitter T12, and a base T13. The collector T11 corresponds to a first high-potential terminal, the emitter T12 corresponds to a first low-potential terminal, and the base T13 corresponds to a first control terminal. The magnitude of a first collector current flowing from the collector T11 to the emitter T12 may be regulated by a first base current flowing from the base T13 to the emitter T12.

The second transistor Tr2 has three terminals, namely, a collector T21, an emitter T22, and a base T23. The collector T21 corresponds to a second high-potential terminal, the emitter T22 corresponds to a second low-potential terminal, and the base T23 corresponds to a second control terminal. The magnitude of a second collector current flowing from the collector T21 to the emitter T22 may be regulated by a second base current flowing from the base T23 to the emitter T22.

The at least one first passive component of the first block B1 includes a plurality of first passive components. The plurality of first passive components includes a first power supply resistor R11, a first ground resistor R12, and a first capacitor C1. The at least one second passive component of the second block B2 includes a plurality of second passive components. The plurality of second passive components includes a second power supply resistor R21, a second ground resistor R22, and a second capacitor C2.

The control power supply E1 is a DC power supply having a positive electrode and a negative electrode and generating a DC control voltage Vc1 of predetermined magnitude between the positive electrode and the negative electrode. The negative electrode of the control power supply E1 is electrically connected to the reference node G1. The control power supply E1 is a power supply for supplying operating power to each of the first transistor Tr1 and the second transistor Tr2. Although two symbols, each representing the control power supply E1, are shown in FIG. 1 for the sake of convenience of description, a single control power supply E1 may actually correspond to each of the two symbols. Alternatively, the amplifier circuit 1 may include two control power supplies E1 as well.

In the first block B1, the first ground resistor R12 is electrically connected between the emitter T12 of the first transistor Tr1 and the reference node G1. The first capacitor C1 is electrically connected between the emitter T12 of the first transistor Tr1 and the first input/output terminal P11. The collector T11 of the first transistor Tr1 is electrically connected to the positive electrode of the control power supply E1 via the first power supply resistor R11.

In the second block B2, the second ground resistor R22 is electrically connected between the emitter T22 of the second transistor Tr2 and the reference node G1. The second capacitor C2 is electrically connected between the emitter T22 of the second transistor Tr2 and the second input/output terminal P21. The collector T21 of the second transistor Tr2 is electrically connected to the positive electrode of the control power supply E1 via the second power supply resistor R21.

In addition, between the first block B1 and the second block B2, the base T13 of the first transistor Tr1 and the collector T21 of the second transistor Tr2 are electrically connected together. In addition, the collector T11 of the first transistor Tr1 and the base T23 of the second transistor Tr2 are also electrically connected together.

Furthermore, the transformer Z1 is electrically connected between the collector T11 of the first transistor Tr1 and the collector T21 of the second transistor Tr2. Specifically, the first terminal Ta1 of the transformer Z1 is electrically connected to the collector T11 of the first transistor Tr1 and the base T23 of the second transistor Tr2. In addition, the second terminal Ta2 of the transformer Z1 is electrically connected to the collector T21 of the second transistor Tr2 and the base T13 of the first transistor Tr1. The transformer Z1 according to this embodiment is implemented as a resistor Ra1.

One terminal of a terminal resistor RT1 is electrically connected to the first input/output terminal P11. The other terminal of the terminal resistor RT1 is electrically connected to signal ground G2. One terminal of a terminal resistor RT2 is electrically connected to the second input/output terminal P21. The other terminal of the terminal resistor RT2 is electrically connected to the signal ground G2.

In the amplifier circuit 1 described above, the circuit configuration of the first block B1 with respect to the first terminal Ta1 of the transformer Z1 and the circuit configuration of the second block B2 with respect to the second terminal Ta2 of the transformer Z1 are the same as each other. The first transistor Tr1, first power supply resistor R11, first ground resistor R12, and first capacitor C1 of the first block B1 respectively correspond to the second transistor Tr2, second power supply resistor R21, second ground resistor R22, and second capacitor C2 of the second block B2. That is to say, the circuit configuration formed by the first transistor Tr1, first power supply resistor R11, first ground resistor R12, and first capacitor C1 and the circuit configuration formed by the second transistor Tr2, second power supply resistor R21, second ground resistor R22, and second capacitor C2 are the same as each other. In other words, the circuit configuration formed by the first transistor Tr1, first power supply resistor R11, first ground resistor R12, and first capacitor C1 and the circuit configuration formed by the second transistor Tr2, second power supply resistor R21, second ground resistor R22, and second capacitor C2 are symmetrical to each other with respect to the transformer Z1.

Thus, the amplifier circuit 1 may have both a configuration in which the first input/output terminals P11, P12 form an input section and the second input/output terminals P21, P22 form an output section and a configuration in which the second input/output terminals P21, P22 form an input section and the first input/output terminals P11, P12 form an output section. That is to say, the amplifier circuit 1 may operate properly even when the first input/output terminals P11, P12 and the second input/output terminals P21, P22 exchange their roles as the input section and the output section. For example, even if hardwiring of the first input/output terminals P11, P12 and hardwiring of the second input/output terminals P21, P22 are exchanged with each other while the first input/output terminals P11, P12 and the second input/output terminals P21, P22 are hardwired, the amplifier circuit 1 may still operate properly.

If the first input/output terminals P11, P12 play the role of an input section, then the second input/output terminals P21, P22 play the role of an output section. In that case, a first input signal X1 is provided to the first input/output terminals P11, P12 and a first output signal Y1 is delivered from the second input/output terminals P21, P22. This operation will be hereinafter referred to as a "first operation." If the second input/output terminals P21, P22 play the role of an input section, then the first input/output terminals P11, P12 play the role of an output section. In that case, a second input signal X2 is provided to the second input/output terminals P21, P22 and a second output signal Y2 is delivered from the first input/output terminals P11, P12. This operation will be hereinafter referred to as a "second operation." The first input signal XI, second input signal X2, first output signal Y1, and second output signal Y2 are each an RF signal having radio frequency components with relatively high frequencies.

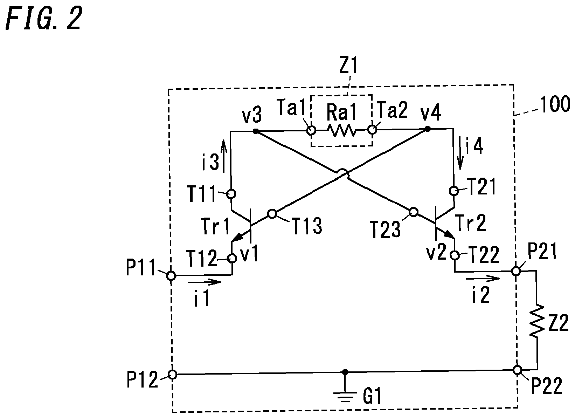

FIG. 2 schematically illustrates a configuration for an NIC circuit for use in the amplifier circuit 1. The NIC circuit shown in FIG. 2 will be hereinafter referred to as an NIC circuit 100. In FIG. 2, the first input signal X1 (see FIG. 1) is provided to the first input/output terminals P11, P12. A load Z2 is electrically connected between the second input/output terminals P21, P22 and the first output signal Y1 (see FIG. 1) is delivered from the second input/output terminals P21, P22. Note that in FIG. 2, illustration of the first power supply resistor R11, first ground resistor R12, first capacitor C1, second power supply resistor R21, second ground resistor R22, second capacitor C2, and control power supply E1 is omitted for the sake of simplicity of description.

In FIG. 2, a first current which is an input current supplied to the first input/output terminal P11 is designated by "i1" and a second current which is output current delivered from the second input/output terminal P21 is designated by "i2." In addition, in FIG. 2, a third current, which is a current flowing from the collector T11 of the first transistor Tr1 to the transformer Z1, is designated by "i3." A fourth current, which is a current flowing from the transformer Z1 to the collector T21 of the second transistor Tr2, is designated by "i4." Furthermore, in FIG. 2, supposing the potential at the reference node G1 (i.e., the potential at the first input/output terminal P12 and the second input/output terminal P22) is a reference potential, a first potential as a potential at the first input/output terminal P11 is designated by "v1" and a second potential as a potential at the second input/output terminal P21 is designated by "v2." Furthermore, in FIG. 2, supposing the potential at the reference node G1 is a reference potential, a third potential as a potential at the first terminal Ta1 of the transformer Z1 is designated by "v3" and a fourth potential as a potential at the second terminal Ta2 of the transformer Z1 is designated by "v4."

In each of the first transistor Tr1 and the second transistor Tr2, if the base-emitter voltage is ignored, then the first to fourth potentials meet the relationship expressed by the following Equation (1):

$$v4 = v1, \qquad v3 = v2 \quad \cdots (1)$$

Also, in each of the first transistor Tr1 and the second transistor Tr2, if a base current which is sufficiently smaller than a collector current and an emitter current is ignored, then the first to fourth currents meet the relationship expressed by the following Equation (2):

$$i1 = i2 = i3 = i4 \quad \cdots (2)$$

Furthermore, if the impedance of the transformer Z1 is designated by "z1" and the impedance of the load Z2 is designated by "z2," these impedances satisfy the following Equations (3) and (4):

$$v3 - v4 = z1 \cdot i3 \quad \cdots (3)$$

$$v2 = z2 \cdot i2 \quad \cdots (4)$$

In this case, the input impedance as viewed from the first input/output terminals P11, P12 is supposed to be designated by "$Z_{in}$." The input impedance of the NIC circuit 100, to which the load Z2 is connected, is given by the following Equation (5) by solving the above Equations (1) to (4) as simultaneous equations:

$$Z_{in} = \frac{v1}{i1} = (-z1) + z2 \quad \cdots (5)$$

That is to say, the input impedance of the NIC circuit 100, to which the load Z2 is connected, is represented as the sum of the impedance of the transformer Z1, of which the sign has been inverted from negative to positive, or vice versa, and the impedance of the load Z2. In other words, the impedance as viewed from the first input/output terminals P11, P12 of the NIC circuit 100 is the impedance, of which the absolute value is the impedance of the transformer Z1 and which is a negative impedance defined by inverting the sign of the impedance of the transformer Z1 from positive to negative, or vice versa. This allows the input impedance of the NIC circuit 100, to which the load Z2 is connected, to be brought closer to zero by making, for example, the impedance of the transformer Z1 and the impedance of the load Z2 equal to each other.

Alternatively, the second input signal X2 may be provided to the second input/output terminals P21, P22 (see FIG. 1), the load Z2 may be electrically connected between the first input/output terminals P11, P12, and the second output signal Y2 (see FIG. 1) may be delivered from the first input/output terminals P11, P12. Even in that case, the NIC circuit 100 also operates in the same way as described above.

In the amplifier circuit 1 based on the NIC circuit 100 described above, the first input signal X1 having radio frequencies and supplied from the first input/output terminals P11, P12 is amplified by an amplification factor determined by the resistor Ra1 and the signal thus amplified is delivered as the first output signal Y1 from the second input/output terminals P21, P22. Meanwhile, the second input signal X2 having radio frequencies and supplied from the second input/output terminals P21, P22 is amplified by the amplification factor determined by the resistor Ra1 and the signal thus amplified is delivered as the second output signal Y2 from the first input/output terminals P11, P12. That is to say, the amplifier circuit 1 is a bidirectional amplifier circuit with the ability to perform amplification operation bidirectionally.

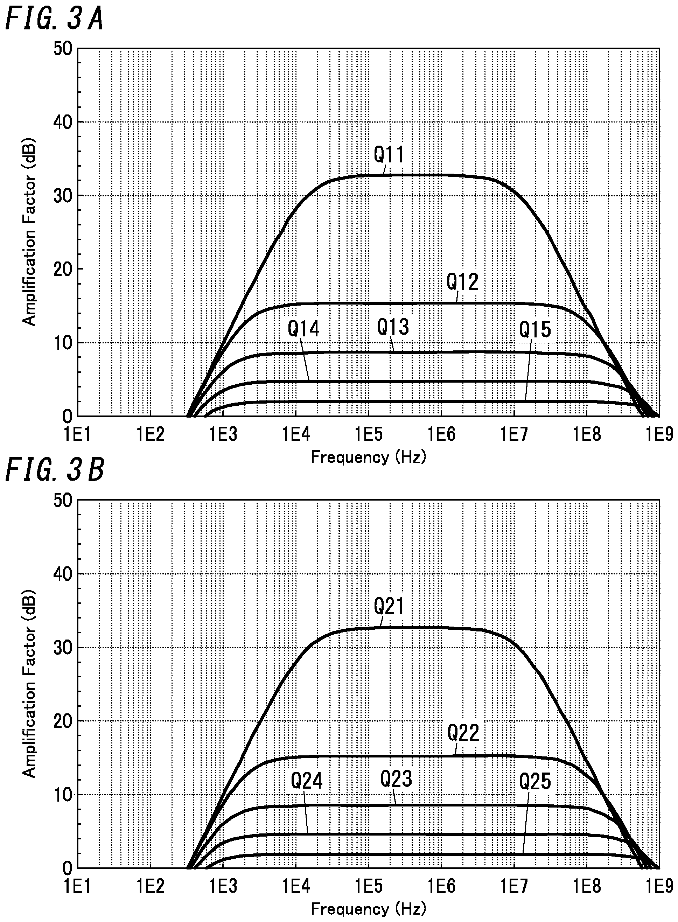

FIG. 3A shows the frequency characteristic of the power amplification factor of the first output signal Y1 with respect to the first input signal X1. In FIG. 3A, the abscissa indicates the frequency of the first input signal X1 and the ordinate indicates the power amplification factor. FIG. 3B shows the frequency characteristic of the power amplification factor of the second output signal Y2 with respect to the second input signal X2. In FIG. 3B, the abscissa indicates the frequency of the second input signal X2 and the ordinate indicates the power amplification factor. In FIGS. 3A and 3B, the frequency on the axis of abscissas is indicated as a common logarithm. In addition, in FIGS. 3A and 3B, the first capacitor C1 and the second capacitor C2 are supposed to have a capacitance of 10 $\mu$F. The first power supply resistor R11, the second power supply resistor R21, the first ground resistor R12, and the second ground resistor R22 are each supposed to have a resistance value of 1 kΩ.

In FIG. 3A, five frequency characteristics Q11-Q15 are shown. The frequency characteristics Q11-Q15 are obtained by setting the resistance of the resistor Ra1 at respectively different values. Specifically, when the resistor Ra1 has a resistance value [Ra11], the frequency characteristic Q11 is obtained. When the resistor Ra1 has a resistance value [Ra12], the frequency characteristic Q12 is obtained. When the resistor Ra1 has a resistance value [Ra13], the frequency characteristic Q13 is obtained. When the resistor Ra1 has a resistance value [Ra14], the frequency characteristic Q14 is obtained. When the resistor Ra1 has a resistance value [Ra15], the frequency characteristic Q15 is obtained. These resistance values [Ra11] to [Ra15] satisfy the inequality [Ra11] > [Ra12] > [Ra13] > [Ra14] > [Ra15]. That is to say, the greater the resistance value of the resistor Ra1 is, the larger the power amplification factor (amplification factor) of the first output signal Y1 with respect to the first input signal X1 becomes. These resistance values [Ra11] to [Ra15] may be each set at a value falling within the range from around a few ten Ω to around several hundred Ω.

In FIG. 3B, five frequency characteristics Q21-Q25 are shown. The frequency characteristics Q21-Q25 are obtained by setting the resistance of the resistor Ra1 at respectively different values. Specifically, when the resistor Ra1 has a resistance value [Ra11], the frequency characteristic Q21 is obtained. When the resistor Ra1 has a resistance value [Ra12], the frequency characteristic Q22 is obtained. When the resistor Ra1 has a resistance value [Ra13], the frequency characteristic Q23 is obtained. When the resistor Ra1 has a resistance value [Ra14], the frequency characteristic Q24 is obtained. When the resistor Ra1 has a resistance value [Ra15], the frequency characteristic Q25 is obtained. That is to say, the greater the resistance value of the resistor Ra1 is, the larger the power amplification factor of the second output signal Y2 with respect to the second input signal X2 becomes.

As shown in FIGS. 3A and 3B, the frequency characteristic of the power amplification factor of the first output signal Y1 with respect to the first input signal X1 and the frequency characteristic of the power amplification factor of the second output signal Y2 with respect to the second input signal X2 are the same (or substantially the same) characteristic. Thus, the amplifier circuit 1 may operate in the same way even if the first input/output terminals P11, P12 and the second input/output terminals P21, P22 exchange their roles as the input and output sections.

In addition, the amplifier circuit 1 is based on the NIC circuit 100, and therefore, may amplify a signal falling within a broad frequency band. As used herein, the "broad frequency band" refers to a frequency band having a bandwidth of three digits or more ($10^3$ or more), for example. In FIGS. 3A and 3B, a relatively high power amplification factor of 25 dB or more is maintained within a range of about 10 kHz to about 20 MHz.

Next, the first power supply resistor R11, the second power supply resistor R21, the first ground resistor R12, and the second ground resistor R22 will be described.

The first power supply resistor R11 and the second power supply resistor R21 are provided for the purpose of attenuating AC components of the control voltage Vc1 and allowing only DC components thereof to pass. The first ground resistor R12 attenuates AC components to make the emitter T12 of the first transistor Tr1 grounded such that the ground impedance with respect to DC components is lower than the ground impedance with respect to AC components. The second ground resistor R22 attenuates AC components to make the emitter T22 of the second transistor Tr2 grounded by a DC method.

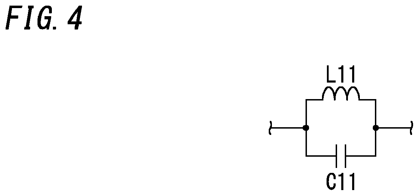

In a comparative example, each of the first power supply resistor R11, the second power supply resistor R21, the first ground resistor R12, and the second ground resistor R22 is replaced by the inductor L11 shown in FIG. 4. However, if the inductance of the inductor L11 is designated by [L11] and the angular frequency thereof is designated by ω, then the impedance of the inductor L11 is given by j·ω·[L11]. Consequently, the lower the frequency of the RF signal passing through the inductor L11 is, the lower the impedance of the inductor L11 becomes and the more likely the RF signal leaks toward the control power supply E1 or the reference node G1 via the inductor L11. To reduce the leakage of the RF signal, the inductance [L11] of the inductor L11 needs to be increased. However, the greater the inductance [L11] of the inductor L11 is, the larger the capacitance (parasitic capacitance) [C11] of a parasitic capacitor C11 (see FIG. 4) connected to the inductor L11 in parallel becomes.

The combined impedance Za of the inductor L11 and the parasitic capacitor C11 is given by the following Equation (6), where the impedance of the inductor L11 is designated by ZL1 and the impedance of the parasitic capacitor C11 is designated by ZC1:

$$Za = \frac{ZL1 \cdot ZC1}{ZL1 + ZC1} = \frac{j \cdot \omega \cdot [L11]}{1 - \omega^2 \cdot [L11] \cdot [C11]} \quad \cdots (6)$$

In the combined impedance Za, the lower the frequency of the RF signal is, the smaller the impedance ZL1 (= j·ω·[L11]) becomes. In addition, in the combined impedance Za, the higher the frequency of the RF signal is, the smaller the impedance ZC1 (= 1/(j·ω·[C11])) becomes. Therefore, the RF signal is more likely to leak toward either the control power supply E1 or the reference node G1, irrespective of the magnitude of the inductance [L11].

For example, an inductor with an inductance [L11] of about 5 $\mu$H and a parasitic capacitance [C11] of about 9 pF may be used as the inductor L11. In that case, the magnitude |ZL1| of the impedance ZL1 and the magnitude |ZC1| of the impedance ZC1 have the respective values shown in the following Table 1 with respect to respective frequencies:

[Table 1]

| Frequency | 10 kHz | 1 MHz | 10 MHz | 100 MHz | 1 GHz |
|---|---|---|---|---|---|
| |ZL1| | 3.14 $\Omega$ | 31.4 $\Omega$ | 314 $\Omega$ | 3.14 k$\Omega$ | 31.4 k$\Omega$ |
| |ZC1| | 177 k$\Omega$ | 17.7 k$\Omega$ | 1.77 k$\Omega$ | 177 $\Omega$ | 17.7 $\Omega$ |

As described above, attempting to use an inductor instead of each of the first power supply resistor R11 and the second power supply resistor R21 would require an inductor with great inductance and very small parasitic capacitance. However, it is difficult to realize such an inductor.

Thus, according to this embodiment, the attenuation characteristic (cutoff characteristic) is substantially equalized over the broad frequency band by using the first power supply resistor R11, the second power supply resistor R21, the first ground resistor R12, and the second ground resistor R22. Note that considering the attenuation characteristic in an RF region, the greater the respective resistance values of the first power supply resistor R11, the second power supply resistor R21, the first ground resistor R12, and the second ground resistor R22 are, the better.

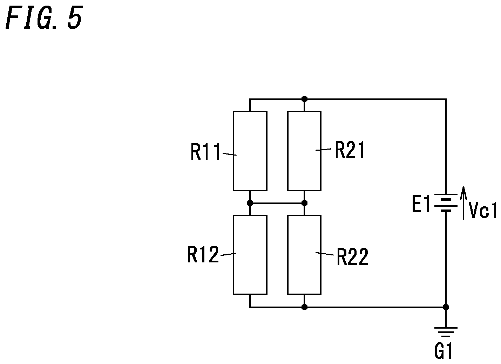

For example, in a situation where "2SC3583" is used as each of the first transistor Tr1 and the second transistor Tr2, if the control voltage Vc1 has a value of 3 V, then a minimum required operating current is 3 mA. In this case, the collector-emitter resistance of each of the first transistor Tr1 and second transistor Tr2 and each resistance value of the resistor Ra1 are smaller than the respective resistance values of the first power supply resistor R11, the second power supply resistor R21, the first ground resistor R12, and the second ground resistor R22. Therefore, the collector-emitter resistance of each of the first transistor Tr1 and second transistor Tr2 and each resistance value of the resistor Ra1 are negligible. In that case, between both terminals of the control power supply E1, the first power supply resistor R11, the second power supply resistor R21, the first ground resistor R12, and the second ground resistor R22 are connected as shown in FIG. 5. Specifically, between both terminals of the control power supply E1, a parallel circuit of the first ground resistor R12 and the second ground resistor R22 is connected in series to a parallel circuit of the first power supply resistor R11 and the second power supply resistor R21. Then, supposing the respective resistance values of the first power supply resistor R11, second power supply resistor R21, first ground resistor R12, and second ground resistor R22 are all equal to each other and designated by [R100], the resistance value between both terminals of the control power supply E1 is also [R100]. Therefore, to set the current supplied from the control power supply E1 at 3 mA when the control voltage Vc1 has a value of 3 V, the resistance value [R100] may be set at about 1 k$\Omega$.

Next, the first capacitor C1 and the second capacitor C2 will be described.

The first capacitor C1 and the second capacitor C2 are coupling capacitors for attenuating DC components. The first capacitor C1 attenuates the DC components of the first input signal X1 or the second output signal Y2. The second capacitor C2 attenuates the DC components of the second input signal X2 or the first output signal Y1.

The lower the frequency is, the larger the impedance of a capacitor becomes. Thus, each capacitance value of the first capacitor C1 and second capacitor C2 is set such that the impedance has a sufficiently low value at a desired lower limit frequency. For example, supposing the lower limit frequency is 100 kHz, the impedances with respect to respective capacitance values are as shown in the following Table 2:

[Table 2]

| Capacitance | 10 $\mu$F | 1 $\mu$F | 100 $\mu$F | 10 nF | 1 nF |
|---|---|---|---|---|---|
| Impedance at 100 kHz | 0.16 $\Omega$ | 1.59 $\Omega$ | 15.9 $\Omega$ | 159 $\Omega$ | 1.59 k$\Omega$ |

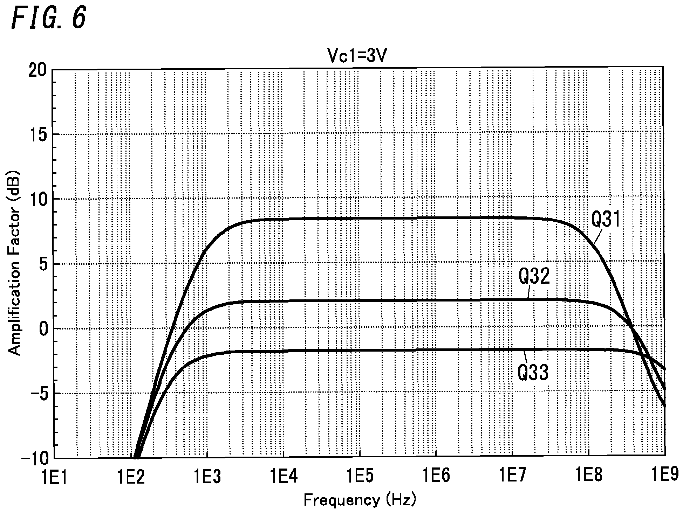

Next, the relationship between the value of the control voltage Vc1 and the amplification factor will be described. The larger the value of the control voltage Vc1 is, the larger the amplification factor tends to be. FIGS. 6, 7, and 8 each show the frequency characteristic of the power amplification factor of the first output signal Y1 with respect to the first input signal X1 (or the second output signal Y2 with respect to the second input signal X2). The frequency on the axis of abscissas is indicated as a common logarithm. In addition, in FIGS. 6, 7, and 8, the first capacitor C1 and the second capacitor C2 are each supposed to have a capacitance of 10 $\mu$F. The first power supply resistor R11, the second power supply resistor R21, the first ground resistor R12, and the second ground resistor R22 are each supposed to have a resistance value of 1 k$\Omega$.

FIG. 6 shows three frequency characteristics Q31-Q33 when the control voltage Vc1 has a value of 3V. The frequency characteristics Q31-Q33 are obtained by setting the resistance of the resistor Ra1 at respectively different values. Specifically, when the resistor Ra1 has a resistance value [Ra16], the frequency characteristic Q31 is obtained. When the resistor Ra1 has a resistance value [Ra17], the frequency characteristic Q32 is obtained. When the resistor Ra1 has a resistance value [Ra18], the frequency characteristic Q33 is obtained. These resistance values [Ra16] to [Ra18] satisfy the inequality [Ra16] > [Ra17] > [Ra18]. That is to say, the greater the resistance value of the resistor Ra1 is, the larger the power amplification factor becomes. These resistance values [Ra16] to [Ra18] may be each set at a value falling within the range from around a few ten $\Omega$ to around several hundred $\Omega$.

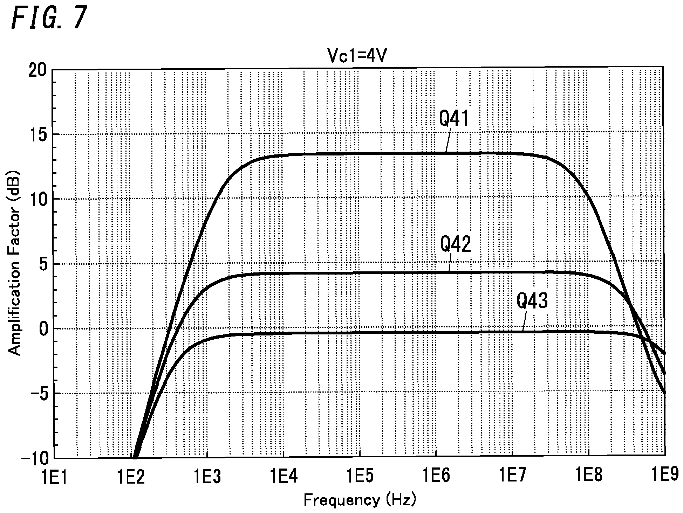

FIG. 7 shows three frequency characteristics Q41-Q43 when the control voltage Vc1 has a value of 4 V. The frequency characteristics Q41-Q43 are obtained by setting the resistance of the resistor Ra1 at respectively different values. Specifically, when the resistor Ra1 has a resistance value [Ra16], the frequency characteristic Q41 is obtained. When the resistor Ra1 has a resistance value [Ra17], the frequency characteristic Q42 is obtained. When the resistor Ra1 has a resistance value [Ra18], the frequency characteristic Q43 is obtained. That is to say, the greater the resistance value of the resistor Ra1 is, the larger the power amplification factor becomes.

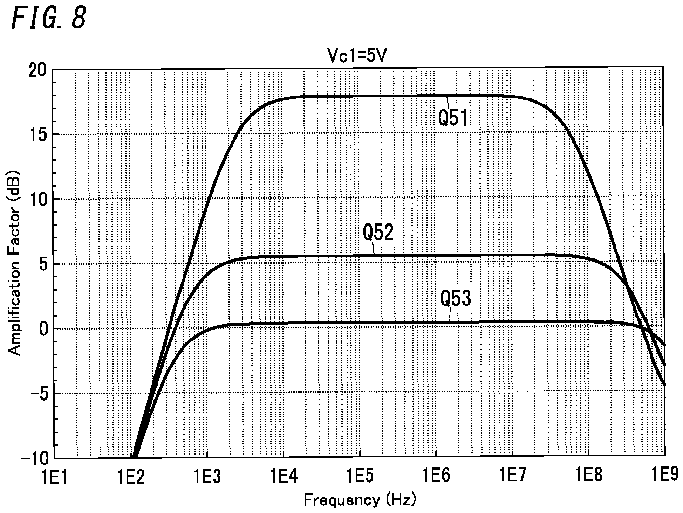

FIG. 8 shows three frequency characteristics Q51-Q53 when the control voltage Vc1 has a value of 5 V. The frequency characteristics Q51-Q53 are obtained by setting the resistance of the resistor Ra1 at respectively different values. Specifically, when the resistor Ra1 has a resistance value [Ra16], the frequency characteristic Q51 is obtained. When the resistor Ra1 has a resistance value [Ra17], the frequency characteristic Q52 is obtained. When the resistor Ra1 has a resistance value [Ra18], the frequency characteristic Q53 is obtained. That is to say, the greater the resistance value of the resistor Ra1 is, the larger the power amplification factor becomes.

Also, comparing the results shown in FIGS. 6, 7, and 8 with each other, it can be seen that the larger the value of the control voltage Vc1 is, the larger the power amplification factor is,

In addition, as can be seen from FIGS. 3, 6, 7, and 8, the power amplification factor varies according to the resistance value of the resistor Ra1. Thus, using a variable resistor as the resistor Ra1 allows the resistance value of the resistor Ra1 to be increased or decreased to make the power amplification factor adjustable. For example, making the resistance value of the resistor Ra1 variable allows the dispersion in the respective characteristics of the first transistor Tr1 and the second transistor Tr2 to be corrected. Also, if the first output signal Y1 or the second output signal Y2 is an audio signal, the volume may be adjusted by making the resistance value of the resistor Ra1 variable. The resistance value of the resistor Ra1 may be varied by either a configuration for varying the resistance value of the resistor Ra1 manually through the user's operation or a configuration for varying the resistance value of the resistor Ra1 automatically without the user's operation.

In addition, in the amplifier circuit 1 according to this embodiment, the circuit configuration of the first block B1 with respect to the first terminal Ta1 of the transformer Z1 and the circuit configuration of the second block B2 with respect to the second terminal Ta2 of the transformer Z1 are the same as each other. In other words, the circuit configuration of the first block B1 and the circuit configuration of the second block B2 are symmetrical to each other with respect to the transformer Z1. Therefore, the amplifier circuit 1 functions as a bidirectional amplifier circuit. When a first input signal X1 is supplied to the first input/output terminals P11, P12 after the first input/output terminals P11, P12 and the second input/output terminals P21, P22 have been hardwired, the first output signal Y1 is delivered from the second input/output terminals P21, P22 (hereinafter referred to as a "first operation"). When a second input signal X2 is supplied to the second input/output terminals P21, P22, the second output signal Y2 is delivered from the first input/output terminals P11, P12 (hereinafter referred to as a "second operation"). The first operation and the second operation are amplification operations to be performed in two opposite directions.

(2) Second embodiment

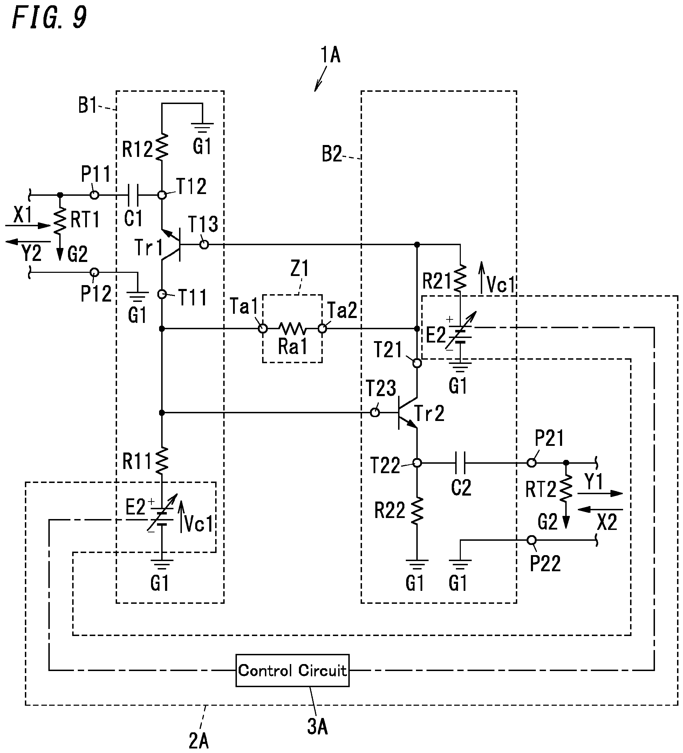

Next, an amplifier circuit according to a second embodiment will be described with reference to FIGS. 9-14. In this embodiment, the amplification factor (power amplification factor) of the first output signal Y1 with respect to the first input signal X1 will be hereinafter referred to as a "first amplification factor $\alpha 1$" and the amplification factor (power amplification factor) of the second output signal Y2 with respect to the second input signal X2 will be hereinafter referred to as a "second amplification factor $\alpha 2$." The amplifier circuit according to this embodiment includes an amplification factor adjustment unit which makes the first amplification factor $\alpha 1$ and the second amplification factor $\alpha 2$ different from each other. The amplification factor adjustment unit's setting the first amplification factor $\alpha 1$ and the second amplification factor $\alpha 2$ at two different values allows the amplifier circuit to be used in a communications device for establishing communication bidirectionally by either full-duplex communication technique or half-duplex communication technique. Examples of such communications devices include transceivers operating in an alternate mode or a momentary mode and intercoms. Note that the amplification factor adjustment unit has an amplification factor adjustment capability of adjusting the amplification factor either actively or passively. That is to say, the amplification factor adjustment unit may have not only a configuration for adjusting the amplification factor by itself but also a configuration for adjusting the amplification factor by letting a constituent element, provided outside of the amplification factor adjustment unit, act on the amplification factor adjustment unit.

In an amplifier circuit including the amplification factor adjustment unit, a circuit configuration formed by the first transistor Tr1, the first power supply resistor R11, the first ground resistor R12, the first capacitor C1, and the amplification factor adjustment unit with respect to the first terminal Ta1 and a circuit configuration formed by the second transistor Tr2, the second power supply resistor R21, the second ground resistor R22, the second capacitor C2, and the amplification factor adjustment unit with respect to the second terminal Ta2 are suitably the same as each other. In other words, the circuit configuration formed by the first transistor Tr1, the first power supply resistor R11, the first ground resistor R12, the first capacitor C1, and the amplification factor adjustment unit and the circuit configuration formed by the second transistor Tr2, the second power supply resistor R21, the second ground resistor R22, the second capacitor C2, and the amplification factor adjustment are suitably symmetrical to each other with respect to the transformer Z1.

In the following description, an operation through which a first input signal X1 is supplied to the first input/output terminals P11, P12 and a first output signal Y1 is delivered from the second input/output terminals P21, P22 will be hereinafter referred to as a "first operation." An operation through which a second input signal X2 is supplied to the second input/output terminals P21, P22 and a second output signal Y2 is delivered from the first input/output terminals P11, P12 will be hereinafter referred to as a "second operation." The amplification factor for the first operation is the first amplification factor $\alpha1$ and the amplification factor for the second operation is the second amplification factor $\alpha2$.

The following description of the second embodiment will be focused on the differences from the amplifier circuit 1 of the first embodiment. In the following description, any constituent element of this second embodiment, having the same function as a counterpart of the first embodiment described above, will be designated by the same reference numeral as that counterpart's, and description thereof will be omitted herein.


(2.1) First example

The amplifier circuit 1A shown in FIG. 9 includes a control power supply E2 instead of the control power supply E1 (see FIG. 1). In addition, the amplifier circuit 1A further includes an amplification factor adjustment unit 2A. The amplification factor adjustment unit 2A includes a control circuit 3A and the control power supply E2.

The control circuit 3A suitably includes a computer system. The computer system may include a processor and a memory as its principal hardware components. The functions of the control circuit 3A may be performed at least partially by making the processor execute a program stored in the memory of the computer system. The program may be stored in advance in the memory of the computer system. Alternatively, the program may also be downloaded through a telecommunications line or be distributed after having been recorded in some non-transitory storage medium such as a memory card, an optical disc, or a hard disk drive, any of which is readable for the computer system. The processor of the computer system may be implemented as a single or a plurality of electronic circuits including a semiconductor integrated circuit (IC) or a large-scale integrated circuit (LSI). As used herein, the "integrated circuit" such as an IC or an LSI is called by a different name depending on the degree of integration thereof. Examples of the integrated circuits include a system LSI, a very large-scale integrated circuit (VLSI), and an ultra-large scale integrated circuit (ULSI). Optionally, a field-programmable gate array (FPGA) to be programmed after an LSI has been fabricated or a reconfigurable logic device allowing the connections or circuit sections inside of an LSI to be reconfigured may also be adopted as the processor. Those electronic circuits may be either integrated together on a single chip or distributed on multiple chips, whichever is appropriate. Those multiple chips may be integrated together in a single device or distributed in multiple devices without limitation. As used herein, the "computer system" includes a microcontroller including one or more processors and one or more memories. Thus, the microcontroller may also be implemented as a single or a plurality of electronic circuits including a semiconductor integrated circuit or a large-scale integrated circuit.

The control power supply E2 is a variable voltage source, of which the DC control voltage Vc1 has variable values. As the control voltage Vc1 increases, the voltage between a first high-potential terminal T11 and a reference node G1 and the voltage between a second high-potential terminal T21 and the reference node G1 increase. As the control voltage Vc1 decreases, the voltage between the first high-potential terminal T11 and the reference node G1 and the voltage between the second high-potential terminal T21 and the reference node G1 decrease.

The control circuit 3A regulates the control voltage Vc1 by controlling the control power supply E2. The control circuit 3A may increase the amplification factor by increasing the value of the control voltage Vc1. The control circuit 3A may decrease the amplification factor by decreasing the value of the control voltage Vc1.

Thus, the control circuit 3A makes the first amplification factor $\alpha1$ for the first operation larger than the second amplification factor $\alpha2$ for the second operation by setting the control voltage Vc1 at the time of the first operation at a value larger than the control voltage Vc1 at the time of the second operation. The control circuit 3A switches the value of the control voltage Vc1 time-sequentially in synch with the change of the operation mode from the first operation to the second operation, and vice versa.

(2.2) Second example

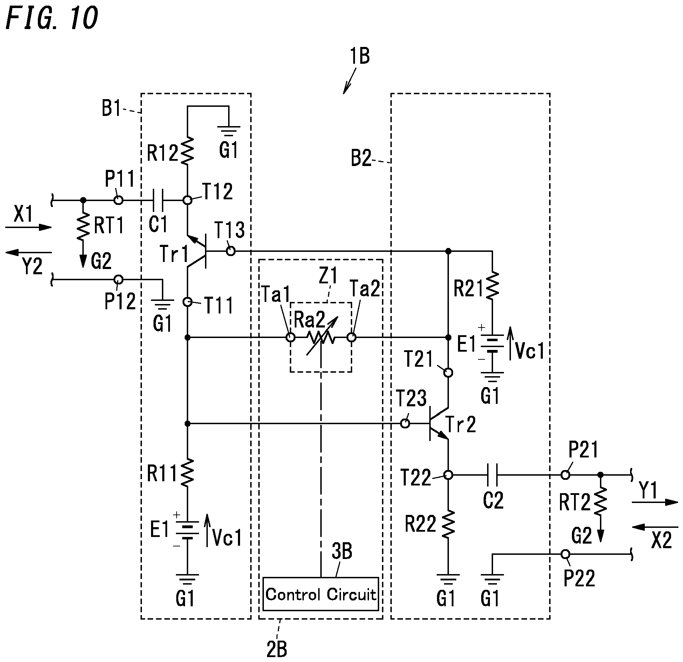

The amplifier circuit 1B shown in FIG. 10 includes a variable resistor Ra2 as the transformer Z1. In addition, the amplifier circuit 1B further includes an amplification factor adjustment unit 2B. The amplification factor adjustment unit 2B includes a control circuit 3B and the variable resistor Ra2.

The control circuit 3B suitably includes a computer system.

The variable resistor Ra2 has variable resistance values. As the resistance value of the variable resistor Ra2 varies, the impedance of the transformer Z1 changes.

The control circuit 3B regulates the resistance value of the variable resistor Ra2 by controlling the variable resistor Ra2. The control circuit 3B may increase the amplification factor by increasing the resistance value of the variable resistor Ra2. In addition, the control circuit 3B may decrease the amplification factor by decreasing the resistance value of the variable resistor Ra2.

Thus, the control circuit 3B makes the first amplification factor $\alpha 1$ for the first operation larger than the second amplification factor $\alpha 2$ for the second operation by setting the resistance value of the variable resistor Ra2 at the time of the first operation at a value larger than the resistance value of the variable resistor Ra2 at the time of the second operation. The control circuit 3B switches the resistance value of the variable resistor Ra2 time-sequentially in synch with the change of the operation mode from the first operation to the second operation, and vice versa.

(2.3) Third example

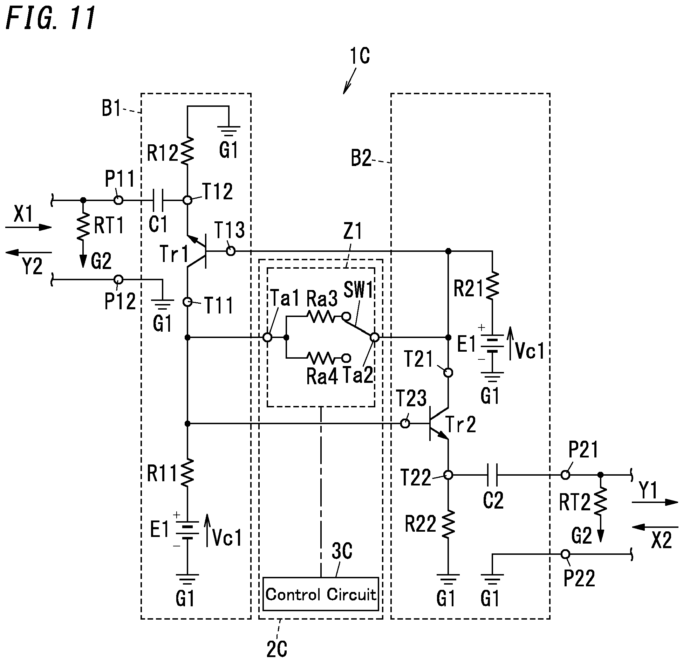

The amplifier circuit 1C shown in FIG. 11 includes, as the transformer Z1, a circuit made up of two resistors Ra3, Ra4 and a single-pole double-throw switch SW1. In addition, the amplifier circuit 1C further includes an amplification factor adjustment unit 2C. The amplification factor adjustment unit 2C includes a control circuit 3C and the transformer Z1.

The control circuit 3C suitably includes a computer system.

The resistors Ra3, Ra4 have mutually different resistance values. In this example, the resistance value of the resistor Ra3 is supposed to be larger than the resistance value of the resistor Ra4. In addition, one end of the resistor Ra3 and one end of the resistor Ra4 are electrically connected to the first terminal Ta1.

The switch SW1 is a single-pole double-throw switch including a moving contact and a pair of fixed contacts. The moving contact of the switch SW1 is electrically connected to the second terminal Ta2. One fixed contact of the switch SW1 is electrically connected to the other end of the resistor Ra3. The other fixed contact of the switch SW1 is electrically connected to the other end of the resistor Ra4. The moving contact of the switch SW1 is electrically connected switchably to one of the pair of fixed contacts. That is to say, switching the connection of the moving contact of the switch SW1 allows either the resistor Ra3 or the resistor Ra4 to be selectively electrically connected between the first terminal Ta1 and the second terminal Ta2. Thus, the combined resistance of the resistors Ra3 and Ra4 formed between the first terminal Ta1 and the second terminal Ta2 may be switched time-sequentially by the switch SW1. In this example, the resistance value of the resistor Ra3 is larger than the resistance value of the resistor Ra4. Therefore, the combined resistance (i.e., the impedance of the transformer Z1) when the resistor Ra3 is electrically connected between the first terminal Ta1 and the second terminal Ta2 is larger than the combined resistance (i.e., the impedance of the transformer Z1) when the resistor Ra4 is electrically connected between the first terminal Ta1 and the second terminal Ta2.

The control circuit 3C switches the connection of the moving contact of the switch SW1 from the resistor Ra3 to the resistor Ra4, or vice versa, by controlling the switch SW1. More specifically, the control circuit 3C selectively connects the moving contact of the switch SW1 to the resistor Ra3 at the time of the first operation and selectively connects the moving contact of the switch SW1 to the resistor Ra4 at the time of the second operation. Since the resistance value of the resistor Ra3 is larger than the resistance value of the resistor Ra4, the first amplification factor $\alpha 1$ at the time of the first operation becomes larger than the second amplification factor $\alpha 2$ at the time of the second operation. The control circuit 3C switches the connection of the moving contact of the switch SW1 time-sequentially in synch with the change of the operation mode from the first operation to the second operation, and vice versa.

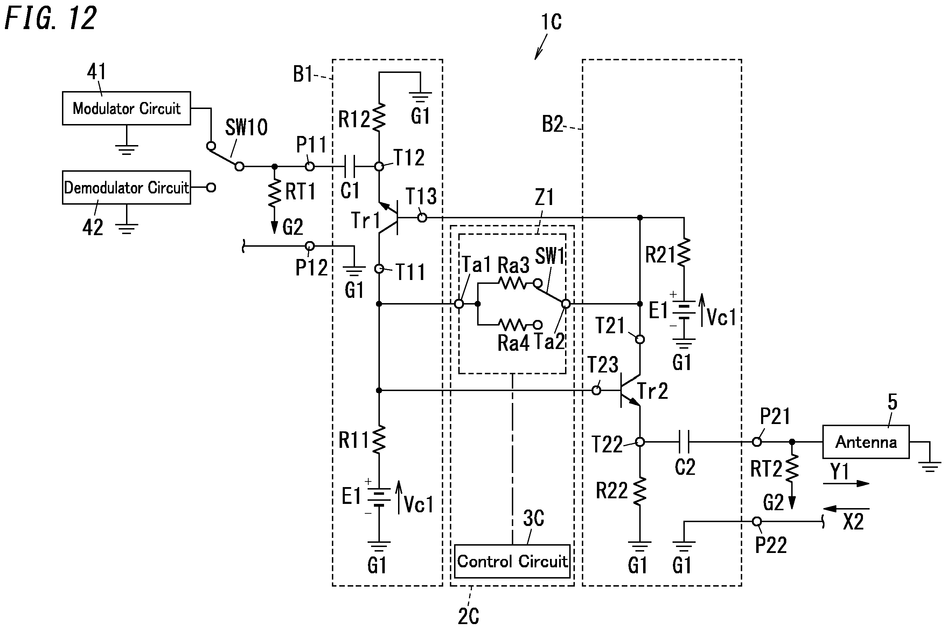

FIG. 12 illustrates an application example in which the amplifier circuit 1C is used in a communications device. In FIG. 12, a modulator circuit 41 and a demodulator circuit 42 of the communications device for establishing wireless communication are electrically connected to the first input/output terminals P11, P12 via a single-pole double-throw switch SW10 and an antenna 5 is electrically connected to the second input/output terminals P21, P22.

The switch SW10 is a single-pole double-throw switch having a moving contact and a pair of fixed contacts. The moving contact of the switch SW10 is electrically connected to the first input/output terminal P11. One fixed contact of the switch SW10 is electrically connected to the modulator circuit 41. The other fixed contact of the switch SW10 is electrically connected to the demodulator circuit 42. The moving contact of the switch SW10 is electrically connected switchably to one of the pair of fixed contacts. That is to say, switching the connection of the moving contact of the switch SW10 allows either the modulator circuit 41 or the demodulator circuit 42 to be selectively electrically connected to the first input/output terminal P11.

The control circuit 3C changes the operation mode from the first operation to the second operation, and vice versa, in synch with switching of the switch SW10. Specifically, the control circuit 3C controls, when the modulator circuit 41 is electrically connected to the first input/output terminals P11, P12, the switch SW1 to perform the first operation. Meanwhile, the control circuit 3C controls, when the demodulator circuit 42 is electrically connected to the first input/output terminals P11, P12, the switch SW1 to perform the second operation.

For example, when communication is established in compliance with the Global System for Mobile communication (GSM®) standard, the amplification factor for upload communication is different from the amplification factor for download communication. Thus, the amplifier circuit 1C may make the first amplification factor $\alpha 1$ applied to an upload signal at the time of the first operation and the second amplification factor $\alpha 2$ applied to a download signal at the time of the second operation different from each other time-sequentially.

(2.4) Fourth example

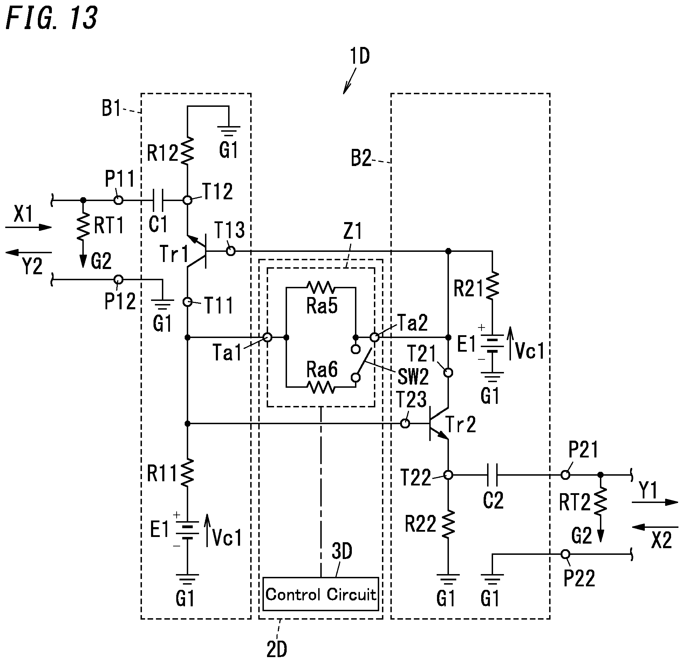

The amplifier circuit 1D shown in FIG. 13 includes, as the transformer Z1, a circuit made up of two resistors Ra5, Ra6 and a single-pole single-throw switch SW2. In addition, the amplifier circuit 1D further includes an amplification factor adjustment unit 2D. The amplification factor adjustment unit 2D includes a control circuit 3D and the transformer Z1.

The control circuit 3D suitably includes a computer system.

The resistors Ra5, Ra6 have mutually different resistance values. In this example, the resistance value of the resistor Ra5 is supposed to be larger than the resistance value of the resistor Ra6. In addition, one end of the resistor Ra5 is electrically connected to the first terminal Ta1 and the other end of the resistor Ra5 is electrically connected to the second terminal Ta2. On the other hand, one end of the resistor Ra6 is electrically connected to the first terminal Ta1 and the other end of the resistor Ra6 is electrically connected to the second terminal Ta2 via the single-pole single-throw switch SW2. That is to say, the combined resistance of the resistors Ra5 and Ra6 connected between the first terminal Ta1 and the second terminal Ta2 is changed by turning the switch SW2 ON (i.e., making the switch SW2 electrically conductive) or OFF (i.e., making the switch SW2 electrically non-conductive).

If the switch SW2 is OFF, the value of the resistance between the first terminal Ta1 and the second terminal Ta2 is equal to the resistance value of the resistor Ra5. On the other hand, if the switch SW2 is ON, then value of the resistance between the first terminal Ta1 and the second terminal Ta2 is equal to the resistance value of a parallel circuit of the resistors Ra5 and Ra6. That is to say, the combined resistance produced between the first terminal Ta1 and the second terminal Ta2 by the resistors Ra5 and Ra6 may be switched time-sequentially by the switch SW2. Specifically, the combined resistance (i.e., the impedance of the transformer Z1) while the switch SW2 is ON is lower than the combined resistance (i.e., the impedance of the transformer Z1) while the switch SW2 is OFF. Thus, the amplification factor while the switch SW2 is ON becomes smaller than the amplification factor while the switch SW2 is OFF.

The control circuit 3D switches the ON/OFF states of the switch SW2 by controlling the switch SW2. More specifically, the control circuit 3D keeps the switch SW2 OFF during the first operation and keeps the switch SW2 ON during the second operation to make the first amplification factor $\alpha 1$ at the time of the first operation larger than the second amplification factor $\alpha 2$ at the time of the second operation. The control circuit 3D switches the ON/OFF states of the switch SW2 time-sequentially in synch with the change of the operation mode from the first operation to the second operation, and vice versa.

(2.5) Fifth example

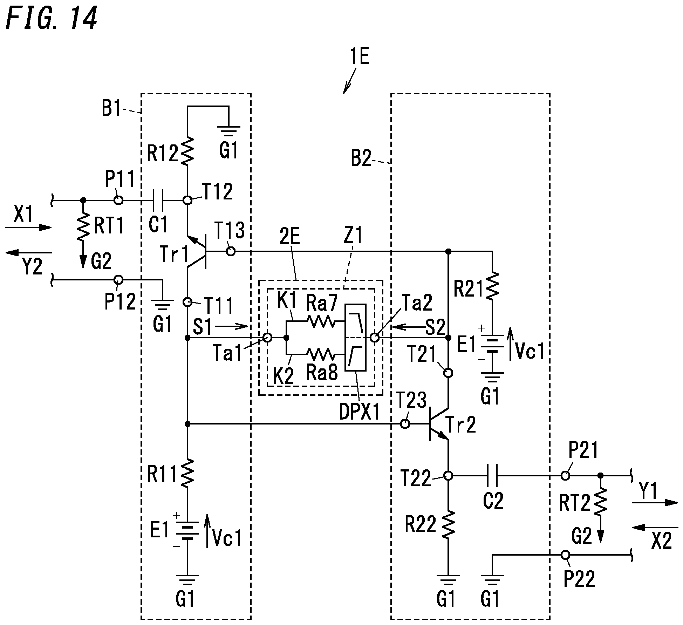

The amplifier circuit 1E shown in FIG. 14 includes, as the transformer Z1, a circuit made up of two resistors Ra7, Ra8 and a duplexer DPX1. In addition, the amplifier circuit 1E further includes an amplification factor adjustment unit 2E. The amplification factor adjustment unit 2E includes the transformer Z1.

The control circuit 3E suitably includes a computer system.

The duplexer DPX1 divides a signal input to the duplexer DPX1 itself into a low-frequency signal and a high-frequency signal. Then, the duplexer DPX1 lets the low-frequency signal pass through a first path K1 and also lets the high-frequency signal pass through a second path K2. The resistor Ra7 is connected to the first path K1 in series, and therefore, the low-frequency signal passes through the resistor Ra7. The resistor Ra8 is connected to the second path K2 in series, and therefore, the high-frequency signal passes through the resistor Ra8.

Thus, if a first signal S1 propagating from the first terminal Ta1 toward the second terminal Ta2 and a second signal S2 propagating from the second terminal Ta2 toward the first terminal Ta1 have mutually different frequencies, then the first amplification factor $\alpha 1$ at the time of the first operation is determined by the resistor Ra7 and the second amplification factor $\alpha 2$ at the time of the second operation is determined by the resistor Ra8.

Therefore, the frequency of a first input signal X1 (corresponding to the first signal S1) is made lower than the frequency of a second input signal X2 (corresponding to the second signal S2). In addition, the resistance values of the resistors Ra7 and Ra8 are also set at mutually different values. This may make the first amplification factor $\alpha 1$ at the

time of the first operation and the second amplification factor α2 at the time of the second operation mutually different from each other.

For example, when communication is established by the code division multiple access (CDMA) method, the frequency for uploading is different from the frequency for downloading. Thus, suppose a modulator circuit and demodulator circuit of a communications device for establishing wireless communication by the CDMA method are electrically connected to the first input/output terminals P11, P12 and an antenna is electrically connected to the second input/output terminals P21, P22. In that case, the amplifier circuit 1E may make the first amplification factor α1 applied to an upload signal at the time of the first operation and the second amplification factor α2 applied to a download signal at the time of the second operation different from each other.

(3) Variations

Note that the embodiment described above is only an exemplary one of various embodiments of the present disclosure and should not be construed as limiting. Rather, the exemplary embodiment may be readily modified in various manners depending on a design choice or any other factor without departing from the scope of the present disclosure. Next, variations of the exemplary embodiment will be enumerated one after another. Optionally, the variations to be described below may be adopted in combination as appropriate.

The embodiment described above may be modified such that the transformer Z1 is implemented as a different type of impedance element such as a capacitor or an inductor, instead of the resistor. Alternatively, the transformer Z1 may also be implemented as a combination of two or more impedance elements selected from a resistor, a capacitor, and an inductor, for example.

The embodiment described above may also be modified such that a modulator circuit and a demodulator circuit for wireless communication are electrically connected to the first input/output terminals P11, P12 and an antenna is electrically connected to the second input/output terminals P21, P22. The amplifier circuit 1 is able to amplify a signal falling within a broad frequency band and may function as a bidirectional amplifier circuit. Thus, the amplifier circuit 1 may be used for multiple different types of wireless communications that use mutually different frequency bands.

The embodiment described above may also be modified such that a master device (or indoor unit) of an intercom system is electrically connected to the first input/output terminals P11, P12 and a slave device (or outdoor unit) of the intercom system is electrically connected to the second input/output terminals P21, P22. The amplifier circuit 1 is able to amplify a signal falling within a broad frequency band and may function as a bidirectional amplifier circuit. Thus, the amplifier circuit 1 may be used to transmit a video signal and an audio signal bidirectionally by using a broad frequency band.

Furthermore, the embodiment described above may also be modified such that the first transistor Tr1 and second transistor Tr2 are implemented as semiconductor switching elements other than the npn bipolar transistors, as long as the first transistor Tr1 and the second transistor Tr2 are semiconductor switching elements having the same function.

(4) Recapitulation

As can be seen from the foregoing description, an amplifier circuit (1, 1A, 1B, 1C, 1D, 1E) according to a first aspect of an exemplary embodiment includes a first block (B1), a second block (B2), a transformer (Z1), and a reference node (G1) and operates as a negative impedance converter circuit (100). The first block (B1) includes a first transistor (Tr1) and at least one first passive component (R11, R12, C1). The second block (B2) includes a second transistor (Tr2) and at least one second passive component (R21, R22, C2). The transformer (Z1) has a first terminal (Ta1) thereof electrically connected to the first transistor (Tr1) and a second terminal (Ta2) thereof electrically connected to the second transistor (Tr2). The reference node (G1) provides a reference potential. A circuit configuration formed by the first transistor (Tr1) and the at least one first passive component (R11, R12, C1) of the first block (B1) with respect to the first terminal (Ta1) and a circuit configuration formed by the second transistor (Tr2) and the at least one second passive component (R21, R22, C2) of the second block (B2) with respect to the second terminal (Ta2) are the same as each other.

This amplifier circuit (1, 1A, 1B, 1C, 1D, 1E) may operate properly even when its input and output sections exchange their roles with each other.

An amplifier circuit (1, 1A, 1B, 1C, 1D, 1E) according to a second aspect of the exemplary embodiment includes a first block (B1), a second block (B2), a transformer (Z1), and a reference node (G1) and operates as a negative impedance converter circuit (100). The first block (B1) includes a first transistor (Tr1) and at least one first passive component (R11, R12, C1). The second block (B2) includes a second transistor (Tr2) and at least one second passive component (R21, R22, C2). The transformer (Z1) has a first terminal (Ta1) thereof electrically connected to the first transistor (Tr1) and a second terminal (Ta2) thereof electrically connected to the second transistor (Tr2). The reference node (G1) provides a reference potential. A circuit configuration formed by the first transistor (Tr1) and the at least one first passive component (R11, R12, C1) of the first block (B1) and a circuit configuration formed by the second transistor (Tr2) and the at least one second passive component (R21, R22, C2) of the second block (B2) are symmetrical to each other with respect to the transformer (Z1).

This amplifier circuit (1, 1A, 1B, 1C, 1D, 1E) may operate properly even when its input and output sections exchange their roles with each other.

In an amplifier circuit (1, 1A, 1B, 1C, 1D, 1E) according to a third aspect of the exemplary embodiment, which may be implemented in conjunction with the first or second aspect, the first transistor (Tr1) suitably includes a first high-potential terminal (T11), a first low-potential terminal (T12), and a first control terminal (T13) to regulate a current flowing from the first high-potential terminal (T11) toward the first low-potential terminal (T12). The second transistor (Tr2) suitably includes a second high-potential terminal (T21), a second low-potential terminal (T22), and a second control terminal (T23) to regulate a current flowing from the second high-potential terminal (T21) toward the second low-potential terminal (T22). The first terminal (Ta1) is electrically connected to the first high-potential terminal (T11). The second terminal (Ta2) is electrically connected to the second high-potential terminal (T21). An impedance between the first low-potential terminal (T12) and the reference node (G1) and an impedance between the second low-potential terminal (T22) and the reference node (G1) are each a negative impedance defined by inverting a sign of an impedance of the transformer (Z1) from positive to negative, or vice versa.

This amplifier circuit (1, 1A, 1B, 1C, 1D, 1E) operates as a negative impedance converter circuit (100). In addition, in this amplifier circuit (1, 1A, 1B, 1C, 1D, 1E), a circuit configuration formed by the first transistor (Tr1) and the at least one first passive component (R11, R12, C1) of the first block (B1) with respect to the first terminal (Ta1) and a circuit configuration formed by the second transistor (Tr2) and the at least one second passive component (R21, R22, C2) of the second block (B2) with respect to the second terminal (Ta2) may be the same as each other. Alternatively, in this amplifier circuit (1, 1A, 1B, 1C, 1D, 1E), a circuit configuration formed by the first transistor (Tr1) and the at least one first passive component (R11, R12, C1) of the first block (B1) and a circuit configuration formed by the second transistor (Tr2) and the at least one second passive component (R21, R22, C2) of the second block (B2) may be symmetrical to each other with respect to the transformer (Z1).

In an amplifier circuit (1, 1A, 1B, 1C, 1D, 1E) according to a fourth aspect of the exemplary embodiment, which may be implemented in conjunction with the third aspect, each of the first transistor (Tr1) and the second transistor (Tr2) is suitably a bipolar transistor. The first high-potential terminal (T11) is a collector of the first transistor (Tr1), the first low-potential terminal (T12) is an emitter of the first transistor (Tr1), and the first control terminal (T13) is a base of the first transistor (Tr1). The second high-potential terminal (T21) is a collector of the second transistor (Tr2), the second low-potential terminal (T22) is an emitter of the second transistor (Tr2), and the second control terminal (T23) is a base of the second transistor (Tr2).

This amplifier circuit (1, 1A, 1B, 1C, 1D, 1E) may operate as a negative impedance converter circuit (100).

An amplifier circuit (1, 1A, 1B, 1C, 1D, 1E) according to a fifth aspect of the exemplary embodiment, which may be implemented in conjunction with the third or fourth aspect, further includes a control power supply (E1) to generate a DC control voltage (Vc1). The at least one first passive component (R11, R12, C1) includes: a first power supply resistor (R11) connected, between the first high-potential terminal (T11) and the reference node (G1), to the control power supply (E1) in series; and a first ground resistor (R12) and a first capacitor (C1), each of which is connected to the first low-potential terminal (T12). The at least one second passive component (R21, R22, C2) includes: a second power supply resistor (R21) connected, between the second high-potential terminal (T21) and the reference node (G1), to the control power supply (E1) in series; and a second ground resistor (R22) and a second capacitor (C2), each of which is connected to the second low-potential terminal (T22). The first high-potential terminal (T11) is electrically connected to the second control terminal (T23), and the second high-potential terminal (T21) is electrically connected to the first control terminal (T13).

This amplifier circuit (1, 1A, 1B, 1C, 1D, 1E) operates as a negative impedance converter circuit (100). In addition, in this amplifier circuit (1, 1A, 1B, 1C, 1D, 1E), a circuit configuration formed by the first transistor (Tr1) and the at least one first passive component (R11, R12, C1) of the first block (B1) with respect to the first terminal (Ta1) and a circuit configuration formed by the second transistor (Tr2) and the at least one second passive component (R21, R22, C2) of the second block (B2) with respect to the second terminal (Ta2) may be the same as each other. Alternatively, in this amplifier circuit (1, 1A, 1B, 1C, 1D, 1E), a circuit configuration formed by the first transistor (Tr1) and the at least one first passive component (R11, R12, C1) of the first block (B1) and a circuit configuration formed by the second transistor (Tr2) and the at least one second passive component (R21, R22, C2) of the second block (B2) may be symmetrical to each other with respect to the transformer (Z1).

An amplifier circuit (1, 1A, 1B, 1C, 1D, 1E) according to a sixth aspect of the exemplary embodiment, which may be implemented in conjunction with any one of the third to fifth aspects, suitably further includes a pair of first input/output terminals (P11, P12) and a pair of second input/output terminals (P21, P22). The pair of first input/output terminals (P11, P12) are electrically connected to the first low-potential terminal (T12) and the reference node (G1), respectively. The pair of second input/output terminals (P21, P22) are electrically connected to the second low-potential terminal (T22) and the reference node (G1), respectively. When a first input signal (X1) is provided to the first input/output terminals (P11, P12), a first output signal (Y1) is delivered from the second input/output terminals (P21, P22). When a second input signal (X2) is provided to the second input/output terminals (P21, P22), a second output signal (Y2) is delivered from the first input/output terminals (P11, P12).

This amplifier circuit (1, 1A, 1B, 1C, 1D, 1E) may function as a bidirectional amplifier circuit.

In an amplifier circuit (1, 1A, 1B, 1C, 1, 1E) according to a seventh aspect of the exemplary embodiment, which may be implemented in conjunction with the sixth aspect, an amplification factor (power amplification factor) of the first output signal (Y1) to the first input signal (X1) and an amplification factor (power amplification factor) of the second output signal (Y2) to the second input signal (X2) are determined by an impedance of the transformer (Z1).

In this amplifier circuit (1, 1A, 1B, 1C, 1D, 1E), the amplification factor is set at a desired value by the impedance of the transformer (Z1).

An amplifier circuit (1, 1A, 1B, 1C, 1D, 1E) according to an eighth aspect of the exemplary embodiment, which may be implemented in conjunction with the sixth aspect, further includes an amplification factor adjustment unit (2A-2E). The amplification factor adjustment unit (2A-2E) makes an amplification factor (power amplification factor) of the first output signal (Y1) to the first input signal (X1) and an amplification factor of the second output signal (Y2) to the second input signal (X2) different from each other.

This amplifier circuit (1, 1A, 1B, 1C, 1D, 1E) is applicable to a full-duplex communications device and a half-duplex communications device that establish bidirectional communication.

In an amplifier circuit (1A) according to a ninth aspect of the exemplary embodiment, which may be implemented in conjunction with the eighth aspect, the amplification factor adjustment unit (2A-2E) suitably switches a voltage (Vc1) between the first high-potential terminal (T11) and the reference node (G1) and a voltage (Vc1) between the second high-potential terminal (T21) and the reference node (G1) time-sequentially.

This amplifier circuit (1A) may easily change the amplification factor time-sequentially.

In an amplifier circuit (1B) according to a tenth aspect of the exemplary embodiment, which may be implemented in conjunction with the eighth aspect, the amplification factor adjustment unit (2B) suitably switches an impedance of the transformer (Z1) time-sequentially.

This amplifier circuit (1B) may easily change the amplification factor time-sequentially.

In an amplifier circuit (1B) according to an eleventh aspect of the exemplary embodiment, which may be implemented in conjunction with the tenth aspect, the transformer (Z1) includes a variable resistor (Ra2), and the amplification factor adjustment unit (2B) suitably switches a resistance value of the variable resistor (Ra2) time-sequentially.

This amplifier circuit (1B) may easily change the amplification factor time-sequentially using the variable resistor (Ra2).

In an amplifier circuit (1C, 1D) according to a twelfth aspect of the exemplary embodiment, which may be implemented in conjunction with the tenth aspect, the transformer (Z1) suitably includes a plurality of resistors (Ra3 and Ra4 or Ra5 and Ra6), and the amplification factor adjustment unit (2C, 2D) switches a combined resistance of the plurality of resistors (Ra3 and Ra4 or Ra5 and Ra6) time-sequentially.

This amplifier circuit (1C, 1D) may easily change the amplification factor time-sequentially.

In an amplifier circuit (1E) according to a thirteenth aspect of the exemplary embodiment, which may be implemented in conjunction with the eighth aspect, the transformer (Z1) suitably includes: a first path (K1) allowing a first signal (S1) to pass through while propagating from the first terminal (Ta1) toward the second terminal (Ta2); and a second path (K2) allowing a second signal (S2) to pass through while propagating from the second terminal (Ta2) toward the first terminal (Ta1). The first path (K1) and the second path (K2) have mutually different impedances. The amplification factor adjustment unit (2E) includes the transformer (Z1).

This amplifier circuit (1E) allows two or more signals with different frequencies to have different amplification factors easily.

In an amplifier circuit (1E) according to a fourteenth aspect of the exemplary embodiment, which may be implemented in conjunction with the thirteenth aspect, the first signal (S1) and the second signal (S2) suitably have mutually different frequencies.

This amplifier circuit (1E) may easily change the amplification factor according to the transmission direction of the signal.

In an amplifier circuit (1) according to a fifteenth aspect of the exemplary embodiment, which may be implemented in conjunction with any one of the first to eighth aspects, the transformer (Z1) is suitably a resistor (Ra1).

This amplifier circuit (1) allows the amplification factor to be set at a desired value according to the resistance value of the resistor (Ra1).

In an amplifier circuit (1) according to a sixteenth aspect of the exemplary embodiment, which may be implemented in conjunction with the fifteenth aspect, the resistor (Ra1) is suitably a variable resistor.

This amplifier circuit (1) allows the amplification factor to be adjusted.

In an amplifier circuit (1A, 1B, 1C, 1D, 1E) according to a seventeenth aspect of the exemplary embodiment, which may be implemented in conjunction with any one of the eighth to fourteenth aspects, a circuit configuration formed by the first transistor (Tr1) and the at least one first passive component (R11, R12, C1) of the first block (B1) and the amplification factor adjustment unit (2A-2E) with respect to the first terminal (Ta1) and a circuit configuration formed by the second transistor (Tr2) and the at least one second passive component (R21, R22, C2) of the second block (B2) and the amplification factor adjustment unit (2A-2E) with respect to the second terminal (Ta2) are suitably the same as each other.

This amplifier circuit (1A, 1B, 1C, 1D, 1E) may easily change the amplification factor according to the transmission direction of the signal.

In an amplifier circuit (1A, 1B, 1C, 1D, 1E) according to an eighteenth aspect of the exemplary embodiment, which may be implemented in conjunction with any one of the eighth to fourteenth aspects, a circuit configuration formed by the first transistor (Tr1) and the at least one first passive component (R11, R12, C1) of the first block (B1) and the amplification factor adjustment unit (2A-2E) and a circuit configuration formed by the second transistor (Tr2) and the at least one second passive component (R21, R22, C2) of the second block (B2) and the amplification factor adjustment unit (2A-2E) are suitably symmetrical to each other with respect to the transformer (Z1).

This amplifier circuit (1A, 1B, 1C, 1D, 1E) may easily change the amplification factor according to the transmission direction of the signal.

Note that the constituent elements according to the third to eighteenth aspects are not essential constituent elements for the amplifier circuit (1) but may be omitted as appropriate.

**Reference Signs List**

| | |
|---|---|
| 1, 1A, 1B, 1C, 1D, 1E | Amplifier Circuit |
| B1 | First Block |
| B2 | Second Block |
| Z1 | Transformer |
| Ra1 | Resistor |
| Ra2 | Variable Resistor |
| Ra3, Ra4, Ra5, Ra6 | Resistor |
| Ta1 | First Terminal |
| Ta2 | Second Terminal |
| G1 | Reference Node |
| Tr1 | First Transistor |
| R11 | First Power Supply Resistor (First Passive Component) |
| R12 | First Ground Resistor (First Passive Component) |
| C1 | First Capacitor (First Passive Component) |
| T11 | First High-Potential Terminal |
| T12 | First Low-Potential Terminal |
| T13 | First Control Terminal |
| Tr2 | Second Transistor |
| R21 | Second Power Supply Resistor (Second Passive Component) |
| R22 | Second Ground Resistor (Second Passive Component) |
| C2 | Second Capacitor (Second Passive Component) |
| 2A-2E | Amplification Factor Adjustment Unit |
| T21 | Second High-Potential Terminal |
| T22 | Second Low-Potential Terminal |
| T23 | Second Control Terminal |
| P11, P12 | Pair of First Input/Output Terminals |
| P21, P22 | Pair of Second Input/Output Terminals |
| E1 | Control Power Supply |
| Vc1 | Control Voltage |
| X1 | First Input Signal |
| X2 | Second Input Signal |
| Y1 | First Output Signal |
| Y2 | Second Output Signal |
| S1 | First Signal |
| S2 | Second Signal |

| K1 | First Path |
|----|-----------|
| K2 | Second Path |

**Claims**

1. An amplifier circuit comprising:

   a first block including a first transistor and at least one first passive component;
   a second block including a second transistor and at least one second passive component;
   a transformer having a first terminal thereof electrically connected to the first transistor and a second terminal thereof electrically connected to the second transistor; and
   a reference node configured to provide a reference potential,
   the amplifier circuit being configured to operate as a negative impedance converter circuit,
   a circuit configuration formed by the first transistor and the at least one first passive component of the first block with respect to the first terminal and a circuit configuration formed by the second transistor and the at least one second passive component of the second block with respect to the second terminal being the same as each other.

2. An amplifier circuit comprising:

   a first block including a first transistor and at least one first passive component;
   a second block including a second transistor and at least one second passive component;
   a transformer having a first terminal thereof electrically connected to the first transistor and a second terminal thereof electrically connected to the second transistor; and
   a reference node configured to provide a reference potential,
   the amplifier circuit being configured to operate as a negative impedance converter circuit,
   a circuit configuration formed by the first transistor and the at least one first passive component of the first block and a circuit configuration formed by the second transistor and the at least one second passive component of the second block being symmetrical to each other with respect to the transformer.

3. The amplifier circuit of claim 1 or 2, wherein

   the first transistor includes a first high-potential terminal, a first low-potential terminal, and a first control terminal configured to regulate a current flowing from the first high-potential terminal toward the first low-potential terminal,
   the second transistor includes a second high-potential terminal, a second low-potential terminal, and a second control terminal configured to regulate a current flowing from the second high-potential terminal toward the second low-potential terminal,
   the first terminal is electrically connected to the first high-potential terminal,
   the second terminal is electrically connected to the second high-potential terminal, and an impedance between the first low-potential terminal and the reference node and an impedance between the second low-potential terminal and the reference node are each a negative impedance defined by inverting a sign of an impedance of the transformer from positive to negative, or vice versa.

4. The amplifier circuit of claim 3, wherein

   each of the first transistor and the second transistor is a bipolar transistor,
   the first high-potential terminal is a collector of the first transistor, the first low-potential terminal is an emitter of the first transistor, and the first control terminal is a base of the first transistor, and
   the second high-potential terminal is a collector of the second transistor, the second low-potential terminal is an emitter of the second transistor, and the second control terminal is a base of the second transistor.

5. The amplifier circuit of claim 3 or 4, further comprising a control power supply configured to generate a DC control voltage, wherein

   the at least one first passive component includes: a first power supply resistor connected, between the first high-potential terminal and the reference node, to the control power supply in series; and a first ground resistor and a first capacitor, each of which is connected to the first low-potential terminal,
   the at least one second passive component includes: a second power supply resistor connected, between the second high-potential terminal and the reference node, to the control power supply in series; and a second ground resistor and a second capacitor, each of which is connected to the second low-potential terminal, and the first high-potential terminal is electrically connected to the second control terminal, and the second high-potential terminal is electrically connected to the first control terminal.

6. The amplifier circuit of any one of claims 3 to 5, further comprising:

   a pair of first input/output terminals which are electrically connected to the first low-potential terminal and the reference node, respectively; and
   a pair of second input/output terminals which are electrically connected to the second low-potential terminal and the reference node, respectively, wherein
   when a first input signal is provided to the first input/output terminals, a first output signal is delivered from the second input/output terminals, and
   when a second input signal is provided to the second input/output terminals, a second output signal is delivered from the first input/output terminals.

7. The amplifier circuit of claim 6, wherein
   an amplification factor of the first output signal to the first input signal and an amplification factor of the second output signal to the second input signal are determined by an impedance of the transformer.

8. The amplifier circuit of claim 6, further comprising an amplification factor adjustment unit configured to make an amplification factor of the first output signal to the first input signal and an amplification factor of the second output signal to the second input signal different from each other.

9. The amplifier circuit of claim 8, wherein
   the amplification factor adjustment unit is configured to switch a voltage between the first high-potential terminal and the reference node and a voltage between the second high-potential terminal and the reference node time-sequentially.

10. The amplifier circuit of claim 8, wherein
    the amplification factor adjustment unit is configured to switch an impedance of the transformer time-sequentially.

11. The amplifier circuit of claim 10, wherein

    the transformer includes a variable resistor, and
    the amplification factor adjustment unit is configured to switch a resistance value of the variable resistor time-sequentially.

12. The amplifier circuit of claim 10, wherein

    the transformer includes a plurality of resistors, and
    the amplification factor adjustment unit is configured to switch a combined resistance of the plurality of resistors time-sequentially.

13. The amplifier circuit of claim 8, wherein

    the transformer includes: a first path allowing a first signal to pass through while propagating from the first terminal toward the second terminal; and a second path allowing a second signal to pass through while propagating from the second terminal toward the first terminal,
    the first path and the second path have mutually different impedances, and
    the amplification factor adjustment unit includes the transformer.

14. The amplifier circuit of claim 13, wherein
    the first signal and the second signal have mutually different frequencies.

15. The amplifier circuit of any one of claims 1 to 8, wherein
    the transformer is a resistor.

**16.** The amplifier circuit of claim 15, wherein
the resistor is a variable resistor.

**17.** The amplifier circuit of any one of claims 8 to 14, wherein
a circuit configuration formed by the first transistor and the at least one first passive component of the first block and the amplification factor adjustment unit with respect to the first terminal and a circuit configuration formed by the second transistor and the at least one second passive component of the second block and the amplification factor adjustment unit with respect to the second terminal are the same as each other.

**18.** The amplifier circuit of any one of claims 8 to 14, wherein
a circuit configuration formed by the first transistor and the at least one first passive component of the first block and the amplification factor adjustment unit and a circuit configuration formed by the second transistor and the at least one second passive component of the second block and the amplification factor adjustment unit are symmetrical to each other with respect to the transformer.

Amended claims under Art. 19.1 PCT

**1.** Currently amended) An amplifier circuit comprising:

a first block including a first transistor and at least one first passive component;
a second block including a second transistor and at least one second passive component;
a transformer having a first terminal thereof electrically connected to the first transistor and a second terminal thereof electrically connected to the second transistor; and
a reference node configured to provide a reference potential,
the amplifier circuit being configured to operate as a negative impedance converter circuit,
a circuit configuration formed by the first transistor and the at least one first passive component of the first block with respect to the first terminal and a circuit configuration formed by the second transistor and the at least one second passive component of the second block with respect to the second terminal being the same as each other,
the first transistor including a first high-potential terminal, a first low-potential terminal, and a first control terminal configured to regulate a current flowing from the first high-potential terminal toward the first low-potential terminal,
the second transistor including a second high-potential terminal, a second low-potential terminal, and a second control terminal configured to regulate a current flowing from the second high-potential terminal toward the second low-potential terminal,
the first terminal being directly electrically connected to the first high-potential terminal and the second control terminal, the second terminal being directly electrically connected to the second high-potential terminal and the first control terminal,
an impedance between the first low-potential terminal and the reference node and an impedance between the second low-potential terminal and the reference node being each a negative impedance defined by inverting a sign of an impedance of the transformer from positive to negative, or vice versa.

**2.** Currently amended) An amplifier circuit comprising:

a first block including a first transistor and at least one first passive component;
a second block including a second transistor and at least one second passive component;
a transformer having a first terminal thereof electrically connected to the first transistor and a second terminal thereof electrically connected to the second transistor; and
a reference node configured to provide a reference potential,
the amplifier circuit being configured to operate as a negative impedance converter circuit,
a circuit configuration formed by the first transistor and the at least one first passive component of the first block and a circuit configuration formed by the second transistor and the at least one second passive component of the second block being symmetrical to each other with respect to the transformer,
the first transistor including a first high-potential terminal, a first low-potential terminal, and a first control terminal configured to regulate a current flowing from the first high-potential terminal toward the first low-potential terminal,
the second transistor including a second high-potential terminal, a second low-potential terminal, and a second control terminal configured to regulate a current flowing from the second high-potential terminal toward the second low-potential terminal,
the first terminal being directly electrically connected to the first high-potential terminal and the second control terminal,

the second terminal being directly electrically connected to the second high-potential terminal and the first control terminal,
an impedance between the first low-potential terminal and the reference node and an impedance between the second low-potential terminal and the reference node being each a negative impedance defined by inverting a sign of an impedance of the transformer from positive to negative, or vice versa.

**3.** (Canceled)

**4.** Currently amended) The amplifier circuit of claim 1 or 2, wherein

each of the first transistor and the second transistor is a bipolar transistor,
the first high-potential terminal is a collector of the first transistor, the first low-potential terminal is an emitter of the first transistor, and the first control terminal is a base of the first transistor, and
the second high-potential terminal is a collector of the second transistor, the second low-potential terminal is an emitter of the second transistor, and the second control terminal is a base of the second transistor.

**5.** Currently amended) The amplifier circuit of claim 1, 2 or 4, further comprising a control power supply configured to generate a DC control voltage, wherein

the at least one first passive component includes: a first power supply resistor connected, between the first high-potential terminal and the reference node, to the control power supply in series; and a first ground resistor and a first capacitor, each of which is connected to the first low-potential terminal,
the at least one second passive component includes: a second power supply resistor connected, between the second high-potential terminal and the reference node, to the control power supply in series; and a second ground resistor and a second capacitor, each of which is connected to the second low-potential terminal, and
the first high-potential terminal is electrically connected to the second control terminal, and the second high-potential terminal is electrically connected to the first control terminal.

**6.** Currently amended) The amplifier circuit of any one of claims 1, 2, 4 or 5, further comprising:

a pair of first input/output terminals which are electrically connected to the first low-potential terminal and the reference node, respectively; and
a pair of second input/output terminals which are electrically connected to the second low-potential terminal and the reference node, respectively, wherein
when a first input signal is provided to the first input/output terminals, a first output signal is delivered from the second input/output terminals, and
when a second input signal is provided to the second input/output terminals, a second output signal is delivered from the first input/output terminals.

**7.** Original) The amplifier circuit of claim 6, wherein
an amplification factor of the first output signal to the first input signal and an amplification factor of the second output signal to the second input signal are determined by an impedance of the transformer.

**8.** Original) The amplifier circuit of claim 6, further comprising an amplification factor adjustment unit configured to make an amplification factor of the first output signal to the first input signal and an amplification factor of the second output signal to the second input signal different from each other.

**9.** Original) The amplifier circuit of claim 8, wherein
the amplification factor adjustment unit is configured to switch a voltage between the first high-potential terminal and the reference node and a voltage between the second high-potential terminal and the reference node time-sequentially.

**10.** Original) The amplifier circuit of claim 8, wherein
the amplification factor adjustment unit is configured to switch an impedance of the transformer time-sequentially.

**11.** Original) The amplifier circuit of claim 10, wherein

the transformer includes a variable resistor, and

the amplification factor adjustment unit is configured to switch a resistance value of the variable resistor time-sequentially.

**12.** Original) The amplifier circuit of claim 10, wherein

the transformer includes a plurality of resistors, and
the amplification factor adjustment unit is configured to switch a combined resistance of the plurality of resistors time-sequentially.

**13.** Original) The amplifier circuit of claim 8, wherein

the transformer includes: a first path allowing a first signal to pass through while propagating from the first terminal toward the second terminal; and a second path allowing a second signal to pass through while propagating from the second terminal toward the first terminal,
the first path and the second path have mutually different impedances, and
the amplification factor adjustment unit includes the transformer.

**14.** Original) The amplifier circuit of claim 13, wherein
the first signal and the second signal have mutually different frequencies.

**15.** Currently amended) The amplifier circuit of any one of claims 1, 2, 4 to 8, wherein
the transformer is a resistor.

**16.** Original) The amplifier circuit of claim 15, wherein
the resistor is a variable resistor.

**17.** Original) The amplifier circuit of any one of claims 8 to 14, wherein
a circuit configuration formed by the first transistor and the at least one first passive component of the first block and the amplification factor adjustment unit with respect to the first terminal and a circuit configuration formed by the second transistor and the at least one second passive component of the second block and the amplification factor adjustment unit with respect to the second terminal are the same as each other.

**18.** Original) The amplifier circuit of any one of claims 8 to 14, wherein
a circuit configuration formed by the first transistor and the at least one first passive component of the first block and the amplification factor adjustment unit and a circuit configuration formed by the second transistor and the at least one second passive component of the second block and the amplification factor adjustment unit are symmetrical to each other with respect to the transformer.

*FIG. 1*

1

B1

R12

G1

P11

X1

RT1

C1 T12

T13

Y2

Tr1

G2

P12

T11

G1

Z1

Ta1 Ta2

Ra1

R21

E1 Vc1

T21

G1

T23

R11

Tr2

E1 Vc1

T22

C2

P21

RT2

Y1

G1

R22

G2

X2

G1

G1

P22

B2

FIG. 2

FIG. 3 A

FIG. 3 B

FIG. 4

*FIG. 5*

*FIG. 6*

FIG. 7

*FIG. 8*

FIG. 9

FIG. 10

*FIG. 11*

FIG. 12

EP 3 930 188 A1

FIG. 13

*FIG. 14*

<table>
<tr><td colspan="2"><b>INTERNATIONAL SEARCH REPORT</b></td><td>International application No.<br>PCT/JP2020/001605</td></tr>
</table>

**A. CLASSIFICATION OF SUBJECT MATTER**
Int. Cl. H03G3/10(2006.01)i, H03H11/10(2006.01)i, H03H11/44(2006.01)i,
H03F1/56(2006.01)i
FI: H03H11/10, H03G3/10 A, H03F1/56, H03H11/44
According to International Patent Classification (IPC) or to both national classification and IPC

**B. FIELDS SEARCHED**

Minimum documentation searched (classification system followed by classification symbols)
Int. Cl. H03G3/10, H03H11/10, H03H11/44, H03F1/56

Documentation searched other than minimum documentation to the extent that such documents are included in the fields searched
Published examined utility model applications of Japan    1922-1996
Published unexamined utility model applications of Japan   1971-2020
Registered utility model specifications of Japan      1996-2020
Published registered utility model applications of Japan  1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y<br><br>A | JP 59-074715 A (NIHON RESUKO KK) 27 April 1984,<br>page 2, lower left column, line 17 to page 6,<br>upper left column, line 3, fig. 4, page 2, lower<br>left column, line 17 to page 6, upper left column,<br>line 3, fig. 4 | 1-8, 10-12,<br>15-18<br>9, 13-14 |
| Y | US 2018/0159642 A1 (BOSE, Tamal) 07 June 2018,<br>paragraph [0063], fig. 9 | 1-8, 10-12,<br>15-18 |
| Y | JP 2017-520985 A (EPCOS AG) 27 July 2017,<br>paragraphs [0047]-[0051], fig. 9 | 7, 15-16 |
| Y | JP 61-133712 A (OKI ELECTRIC INDUSTRY CO., LTD.)<br>21 June 1986, page 2, upper left column, line 19<br>to page 3, upper left column, line 2, fig. 1 | 8, 10-12, 15-<br>18 |

☐ Further documents are listed in the continuation of Box C.    ☒ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>05.03.2020 | Date of mailing of the international search report<br>17.03.2020 |
|---|---|
| Name and mailing address of the ISA/<br>    Japan Patent Office<br>    3-4-3, Kasumigaseki, Chiyoda-ku,<br>    Tokyo 100-8915, Japan | Authorized officer<br><br><br>Telephone No. |

Form PCT/ISA/210 (second sheet) (January 2015)

INTERNATIONAL SEARCH REPORT
Information on patent family members

International application No.

PCT/JP2020/001605

| Patent Documents referred to in the Report | Publication Date | Patent Family | Publication Date |
|---|---|---|---|
| JP 59-074715 A | 27.04.1984 | US 4554415 A<br>column 2, line 9 to<br>column 8, line 3,<br>fig. 4<br>GB 2129637 A | |
| US 2018/0159642 A1 | 07.06.2018 | (Family: none) | |
| JP 2017-520985 A | 27.07.2017 | US 2017/0155371 A1<br>paragraphs [0069]-<br>[0073], fig. 9<br>WO 2016/000872 A1<br>DE 102014109264 A1 | |
| JP 61-133712 A | 21.06.1986 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005286516 A